# DEMANDE DE BREVET EUROPEEN

(11) **EP 0 775 766 A1**
(43) Date de publication de la demande: **28.05.1997**
(21) Numéro de dépôt: 96402504.3
(22) Date de dépôt: 21.11.1996
(51) Int. Cl.: C30B 11/00

(54) **Four de cristallisation pour matériau à faible conductivité thermique et/ou faible dureté**

(30) Priorité: 23.11.1995 FR 9513934
(71) Demandeur: COMMISSARIAT A L'ENERGIE ATOMIQUE, 75015 Paris Cédex 15 (FR)
(72) Inventeur: Petroz, Gérard, 38330 Montbonnot (FR)
(74) Mandataire: Dubois-Chabert, Guy

(57) **Abrégé**

L'invention concerne un four de cristallisation pour matériau à faible conductivité thermique et/ou faible dureté.

Ce four permet d'obtenir des monocristaux de qualité.

Ce four comprend une enceinte chauffante (1), des moyens de chauffage (13) pour établir un profil de température selon l'axe de ladite enceinte et définir ainsi au moins une zone chaude (3) et au moins une zone froide (5) et un creuset (9) rempli d'une solution de soluté à cristalliser, dans un solvant, ledit creuset (9) étant fixe et étant placé dans l'enceinte chauffante (1) au niveau de la zone chaude (3), caractérisé en ce que le four comprend de plus :
- un dispositif de cristallisation (27) comprenant un homogénéïsateur thermique (29A) et un drain thermique (29B) séparés par une entretoise (31) thermiquement isolante, lesdits homogénéisateur thermique, drain thermique et entretoise isolante étant solidaires, et
- des moyens (37) pour déplacer ledit dispositif de cristallisation (27) selon l'axe de l'enceinte et autour dudit creuset (9).

## Description

La présente invention concerne un four de cristallisation destiné à la fabrication de monocristaux d'un matériau présentant une faible conductivité thermique et/ou une faible dureté.

Le four selon l'invention s'applique notamment à la fabrication de monocristaux par la méthode dite de "BRIDGMAN", méthode selon laquelle on refroidit selon un gradient thermique, une solution comprenant un soluté dissous dans un solvant, de façon à provoquer la solidification contrôlée de ce soluté. La réussite de l'opération métallurgique est liée au contrôle du gradient thermique utilisé. Toutefois, le four de cristallisation selon l'invention peut également s'appliquer à d'autres types de fabrication de monocristaux, en particulier à la purification par liquéfaction et recristallisation.

La méthode BRIDGMAN utilise un four du même nom. Ce four permet la création d'un ou de plusieurs gradients thermiques par la juxtaposition de zones chauffantes contrôlées individuellement et qui présentent un système d'ajustement du chauffage. Ce four BRIDGMAN comprend une enceinte chauffante, des moyens de chauffage permettant d'établir un profil de température selon l'axe de ladite enceinte et définir ainsi au moins une zone chaude et une zone froide et enfin un creuset rempli d'une solution de soluté à cristalliser. Le terme "zone froide" signifie que la température dans cette zone est inférieure à celle régnant dans la "zone chaude", mais il s'agit néanmoins d'une zone de chauffage.

Le creuset ouvert ou fermé contenant le matériau liquide est déplacé du haut au bas de l'enceinte verticale, de la zone chaude vers la zone froide, ce qui provoque la solidification et la cristallisation du matériau. En général, ce four est supporté sur un châssis qui comprend un dispositif de translation verticale du creuset et éventuellement un dispositif de rotation, ainsi qu'un ensemble électrique d'alimentation et de contrôle. Selon la nature du produit à cristalliser, la configuration interne du four et les matériaux utilisés pour la fabrication du creuset et de l'enceinte peuvent varier. Un tel four est décrit par exemple dans le document FR 2 332 799 de la déposante.

L'invention concerne plus particulièrement, bien que pas uniquement, la fabrication de monocristaux d'un matériau ne présentant pas de caractéristiques physiques favorables à l'obtention de cristaux de qualité. Ainsi, si la dureté d'un matériau est faible à température ambiante, on comprend aisément qu'à la température de cristallisation, le réseau cristallin est très fragile et que des vibrations de toutes origines génèrent des défauts dans le solide, préjudiciables à la qualité du cristal obtenu. On observe ainsi des formes de mosaïques, des macles, des sous-grains, des dislocations du réseau cristallin ou encore des grains présentant une orientation différente. De ce fait, le rendement d'obtention de ces cristaux, la reproductibilité du procédé utilisé et la qualité intrinsèque des cristaux obtenus peuvent être extrêmement aléatoires.

Par ailleurs, certains matériaux présentent une autre caractéristique défavorable à une bonne solidification, c'est-à-dire une solidification générant un monocristal en quantité et qualité suffisantes. Il s'agit de leur faible conductivité thermique. Lorsque le liquide se solidifie, cela génère des calories à l'interface de croissance du cristal qu'il est nécessaire d'évacuer assez rapidement en particulier par le solide. Une faible conductivité thermique a tendance à créer un front de croissance concave, ce qui entraîne l'obtention d'un monocristal de mauvaise qualité. Il est donc nécessaire d'évacuer les calories de solidification du cristal tout en respectant les gradients thermiques adaptés à la formation du cristal.

A titre d'exemple, les matériaux à base de manganèse, de titane, de bismuth, de sélénium, de tellure ou de terres rares comme le gadolinium ou le samarium présentent généralement une faible dureté à température ambiante et/ou une mauvaise conductivité thermique.

Les diverses solutions connues pour obtenir des cristaux de qualité ne sont pas très convaincantes. On peut citer à titre d'exemple les résultats obtenus dans l'article de G. T. NEUGEBAUER et al., SPIE-The International Society for Optical Engineering, vol. 2228, 1-10.

L'invention a pour but la mise au point d'un four de cristallisation qui permet d'augmenter très sensiblement le rendement, la reproductibilité et la qualité des monocristaux obtenus.

A cet effet, l'invention concerne un four de cristallisation pour matériau à faible conductivité thermique et/ou faible dureté, comprenant une enceinte chauffante, des moyens de chauffage pour établir un profil de température selon l'axe de ladite enceinte et définir ainsi au moins une zone chaude et au moins une zone froide et un creuset rempli d'une solution de soluté à cristalliser, dans un solvant. Ce four peut être vertical ou horizontal.

Ledit creuset est fixe et est placé dans l'enceinte chauffante au niveau de la zone chaude. Selon les caractéristiques de l'invention, le four comprend de plus :
- un dispositif de cristallisation comprenant un homogénéisateur thermique et un drain thermique séparés par une entretoise thermiquement isolante, lesdits homogénéisateur thermique, drain thermique et entretoise isolante étant solidaires, et
- des moyens pour déplacer ledit dispositif de cristallisation selon l'axe de l'enceinte et autour dudit creuset.

De préférence, le creuset est monté sur un dispositif anti-vibrations.

Le fait que le creuset soit statique, et qu'il soit placé sur des plots anti-vibration permet d'éliminer totalement les vibrations qui induisent d'une part des contraintes mécaniques sur le cristal en cours de solidification et d'autre part, des fluctuations thermiques au niveau de l'interface solide-liquide. On obtient ainsi un monocristal de parfaite qualité.

Par ailleurs, l'homogénéisateur thermique joue précisement un rôle d'homogénéisation de la température du matériau liquide présent dans le creuset, l'entretoise thermiquement isolante crée le gradient de température nécessaire à la cristallisation du matériau et enfin le drain thermique permet d'évacuer par conduction vers le bas les calories rayonnées par la fraction solide du cristal.

Par ailleurs, le dispositif de cristallisation peut éventuellement comprendre un écran tubulaire, isolant thermique, coaxial à l'homogénéisateur thermique et au drain thermique et entourant le drain thermique et l'entretoise isolante. Un tel écran améliore l'effet de drain thermique.

De façon avantageuse, le drain thermique présente un fond en matériau conducteur thermique.

Grâce à cette caractéristique de l'invention, (et notamment lorsque le four est vertical), en cas de rupture du creuset, le matériau liquide est retenu en particulier dans le drain thermique. L'enceinte chauffante du four est donc elle-même protégée. Dans les fours de l'art antérieur, l'intérieur de l'enceinte était protégé par un tube de garde réalisé en général en quartz ou en alumine. La présence de ce tube de garde qui est aussi un isolant thermique en général, impose d'utiliser un surcroît de puissance du four qui peut atteindre jusqu'à 10% de la valeur utile dans la solution proposée par l'invention. L'invention permet donc un gain sensible sur la puissance utile du four ainsi qu'un gain sur le rapport : diamètre du creuset/diamètre de l'enceinte du four. On peut donc réaliser des cristaux de plus gros diamètre pour un même diamètre de four. Ensuite, le confinement ainsi réalisé autour du creuset diminue très sensiblement les mouvements de convexion des gaz qui sont responsables des variations thermiques préjudiciables à une cristallisation homogène. En particulier, on réduit considérablement l'effet de cheminée que l'on retrouve dans la plupart des fours classiques.

Selon une variante de réalisation, l'enceinte chauffante est fermée et remplie d'un gaz circulant à faible débit, ce gaz étant choisi parmi un gaz inerte, réducteur, oxydant ou un gaz comprenant un produit de dopage à l'état gazeux.

Ceci permet de réduire très sensiblement les mouvements de convection naturels des gaz, d'améliorer les échanges thermiques dans l'enceinte et de traiter des matériaux sensibles à l'air.

L'invention sera mieux comprise à la lecture de la description suivante de deux modes de réalisation préférentiels de l'invention, donnés à titre d'exemples illustratifs et non limitatifs, cette description étant faite en faisant référence aux dessins joints, dans lesquels :
- la figure 1 est un schéma d'ensemble du four de cristallisation selon un premier mode de réalisation de l'invention,
- les figures 2A, 2B, 2C sont des schémas représentant le fonctionnement du four de cristallisation selon l'invention,
- la figure 3 est un graphique représentant les températures en différents points de l'homogénéïsateur thermique, du drain thermique, et de l'entretoise isolante en fonction du déplacement du dispositif de cristallisation de l'invention, et.
- la figure 4 est un schéma d'un second mode de réalisation du four.

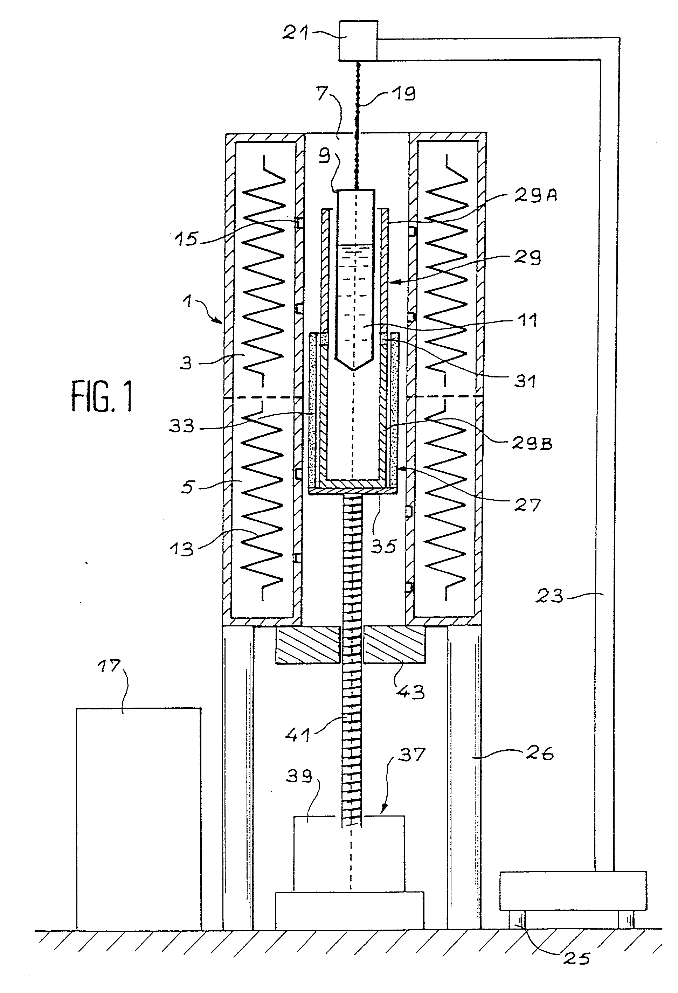

Comme illustré en figure 1, le four de cristallisation selon l'invention comprend une enceinte chauffante 1, comprenant au moins une zone chaude 3 et une zone froide 5. Les parois de l'enceinte chauffante 1 délimitent une cavité centrale 7 dans laquelle est disposé un creuset 9 rempli d'une solution de soluté à cristalliser 11. Les parois de l'enceinte sont munies de moyens de chauffage 13 constitués généralement par des résistances chauffantes électriques. Par ailleurs, ces parois présentent également des capteurs de température 15 généralement constitués par des thermocouples et qui permettent de réguler et de contrôler le gradient thermique souhaité à l'intérieur du four de cristallisation. Ces capteurs de température sont généralement placés à la surface de la paroi intérieure du four.

Le four de cristallisation comprend en outre des moyens de contrôle et d'alimentation électrique 17 reliés aux résistances électriques 13 et aux capteurs de température 15, cette liaison n'étant pas représentée sur la figure 1 à des fins de simplification.

Le creuset 9 est suspendu à l'intérieur de l'enceinte chauffante 1 par l'intermédiaire d'un câble 19, ce dernier pouvant être remplacé par tout autre équivalent du type tige ou chaîne. Ce câble 19 est relié à un dispositif 21 de réglage fin de la position du creuset à l'intérieur de l'enceinte chauffante. Ce dispositif 21 permet d'assurer le déplacement et le centrage du creuset à l'intérieur de l'enceinte, de façon très précise. Le dispositif 21 est monté sur une potence 23, elle-même munie de plots anti-vibration 25 destinés à éviter toute vibration du creuset et donc diminuer les risques de dislocation ou d'apparition de grains d'orientation différente dans le cristal formé durant l'étape de cristallisation.

L'enceinte chauffante 1 du four est posée sur un support 26.

Le four selon l'invention comprend en outre un dispositif de cristallisation 27. Ce dispositif de cristallisation comprend un homogénéisateur thermique 29A et un drain thermique 29B séparés par une entretoise 31 thermiquement isolante, lesdits homogénéisateur thermique, drain thermique, et entretoise isolante étant solidaires, et éventuellement un écran tubulaire isolant thermique 33. Cet écran est coaxial à l'homogénéisateur thermique, au drain thermique et à l'entretoise isolante et entoure le drain thermique 29B et l'entretoise isolante 31.

Le matériau isolant thermique constituant l'entretoise 31 et l'écran tubulaire 33 est choisi par exemple parmi l'alumine, la zircone et les ciments réfractaires.

En outre, selon une variante de réalisation, le drain thermique 29B peut être fermé par un fond 35 en matériau conducteur thermique. Ce matériau est généralement le même que celui utilisé pour l'homogénéïsateur thermique et le drain thermique.

Le dispositif de cristallisation est muni de moyens de déplacement 37 assurant le déplacement en translation du dispositif de cristallisation selon l'axe de l'enceinte et autour du creuset 9. Ces moyens de déplacement 37 sont par exemple constitués d'un moteur 39 et d'une vis sans fin 41, cette vis étant montée sur le fond 35 du dispositif de cristallisation. Ces moyens de déplacement 37 peuvent également être constitués par un piston.

Selon une variante de réalisation, il est possible de prévoir des moyens de refroidissement 43 de la vis sans fin 41 ou plus généralement de l'axe assurant le déplacement du dispositif de cristallisation 27. Ce dispositif de refroidissement 43 est disposé autour de la vis ou axe 41 à l'extérieur de l'enceinte chauffante 1. Ce dispositif est par exemple constitué par un serpentin rempli d'un fluide de refroidissement.

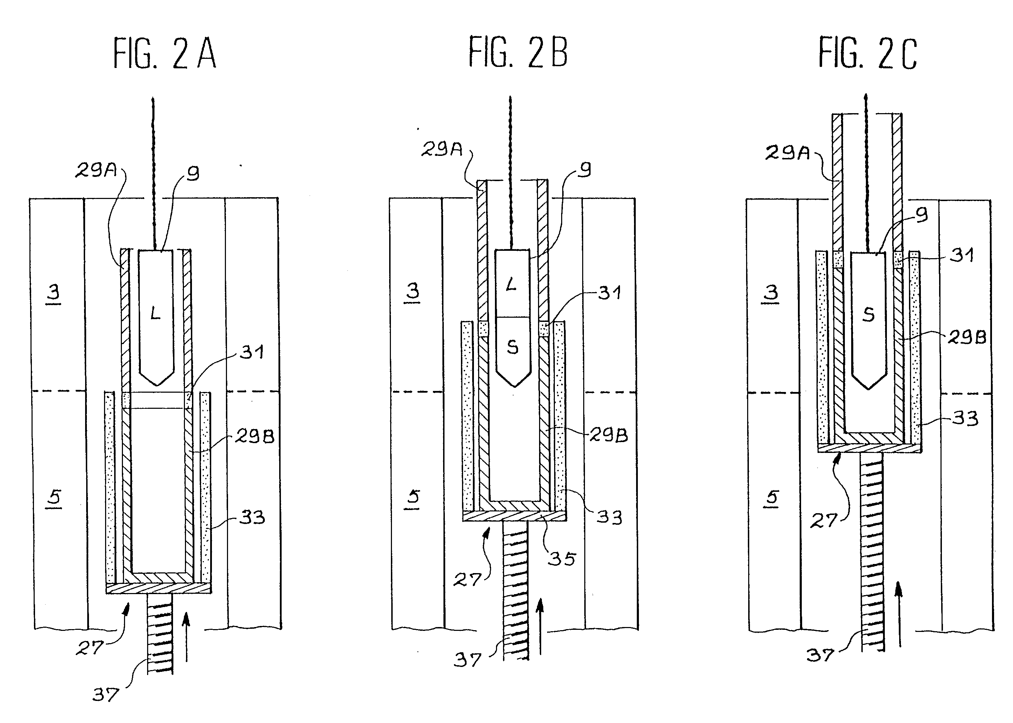

Le fonctionnement du four de cristallisation selon l'invention va maintenant être expliqué plus en détail en faisant référence aux figures 2A, 2B, 2C.

La figure 2A illustre d'une façon schématique une partie du four de cristallisation avant la mise en fonctionnement du four. Le creuset 9 est positionné dans l'enceinte du four de façon à se trouver intégralement dans la zone chaude 3. Par ailleurs, le dispositif de cristallisation 27 est en position basse, c'est-à-dire que l'extrémité supérieure de la bague isolante 31 est en dessous de l'extrémité du fond du creuset 9. Seul l'homogénéisateur thermique 29A entoure le creuset 9. En conséquence, la solution de soluté à cristalliser est sous forme liquide L. L'homogénéisateur thermique 29A joue un rôle d'homogénéisation thermique pour le liquide se trouvant dans le creuset 9.

Sous l'action du dispositif de déplacement 37, le dispositif de cristallisation 27 se déplace en translation vers la partie supérieure de l'enceinte du four jusqu'à arriver à la position représentée sur la figure 2B. Le liquide se trouvant dans le creuset 9 se solidifie au fur et à mesure que l'entretoise isolante 31 passe devant le creuset en isolant ainsi celui-ci de la zone chaude 3 de l'enceinte du four. Sur la figure 2B, toute la partie inférieure du creuset est donc solidifiée (référence S). Par ailleurs, le drain thermique 29B permet d'évacuer par conduction vers le bas de l'enceinte, les calories rayonnées par la fraction solide S du matériau à cristalliser. Le fond 35 participe également à l'évacuation des calories. L'écran tubulaire 33 favorise d'une part le rôle de l'entretoise isolante 31 en formant une épaisseur supplémentaire d'isolant à son voisinage et favorise d'autre part, le rôle de drain thermique du drain thermique 29B en isolant ce drain thermique 29B de la zone chaude 3.

La figure 2C illustre la position du dispositif de cristallisation du four en fin de course, lorsque la totalité du matériau présent dans le creuset est solidifiée. Dans ce cas, l'entretoise isolante 31 se trouve à la partie supérieure du creuset 9.

Les longueurs de l'entretoise isolante 33, du drain thermique 29B et de l'écran tubulaire 33 sont calculées de façon qu'en fin de course du dispositif de cristallisation, une partie de cet écran tubulaire 33 et une partie du drain thermique 29B se trouvent en face de la zone froide 5, pour que le drain thermique 29B puisse continuer à jouer son rôle de drain thermique.

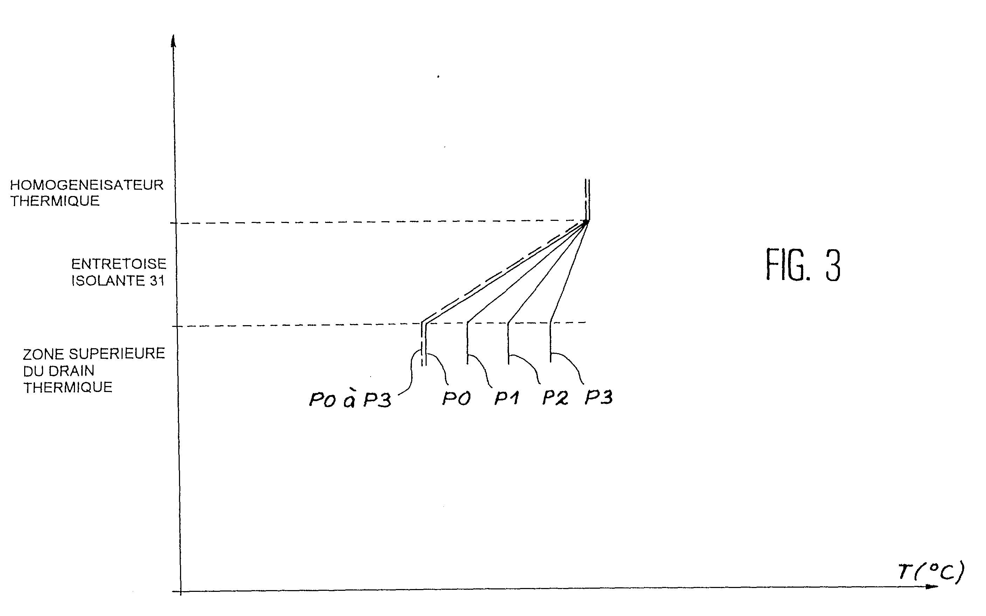

De façon avantageuse, les résistances chauffantes 13 de la zone froide 5 sont commandées par les moyens de contrôle et d'alimentation électrique 17, de façon que la température de la zone froide 5 décroîsse dans le temps, au fur et à mesure de l'avancement du dispositif de cristallisation 27. Les effets bénéfiques de cet abaissement de température sont illustrés sur les courbes de la figure 3.

La figure 3 représente la température de l'entretoise isolante 31, et de l'homogénéïsateur thermique 29A et du drain thermique 29B en fonction de quatre positions successives P0, P1, P2 et P3 occupées par le dispositif de cristallisation lors de son déplacement à l'intérieur de l'enceinte chauffante 1. Les positions P0 et P3 du dispositif de cristallisation correspondent à celles représentées respectivement sur les figures 2A et 2C. Les positions P1 et P2 sont des positions intermédiaires occupées par le dispositif de cristallisation. Les droites en traits pleins correspondent aux résultats observés sans refroidissement dans le temps de la zone froide 5 et la droite en traits pointillés aux résultats obtenus avec le refroidissement de la zone 5.

L'homogénéïsateur thermique 29A reste en permanence en face de la zone chaude 3, au cours du déplacement du dispositif de cristallisation. En conséquence, sa température reste constante dans le temps.

La température du drain thermique 29B est mesurée en un point P situé à proximité de l'entretoise isolante 31. Cette température est relativement basse (voir courbe P0) lorsque le dispositif de cristallisation est dans la position illustrée en figure 2A, puisque ce point P est en face de la zone froide 5. Par contre, au fur et à mesure du déplacement du drain thermique 29B en face de la zone chaude 3, la température de ce point P augmente, (voir courbes P1, P2 et P3), puisque le drain thermique 29B joue de moins en moins ce rôle d'un drain thermique.

Enfin, la température de l'entretoise isolante décroît sur toute sa hauteur mais croît globalement lors du déplacement du dispositif de cristallisation entre les positions P0 et P3.

Par contre, si l'on refroidit continuellement la zone froide 5, le gradient de température reste stable au cours du déplacement du dispositif de cristallisation, comme illustré par la droite en traits pointillés de la figure 3. La différence de température entre l'homogénéïsateur thermique 29A et le drain thermique 29B reste plus importante, ce qui renforce le rôle de drain thermique de la partie 29B.

Le programme de refroidissement progressif dans le temps de la zone froide 5 peut également être remplacé par la réalisation de plusieurs zones froides 5 dont la température, constante dans chaque zone, décroît d'une zone à l'autre entre la zone chaude 3 du four et la partie inférieure de ce four.

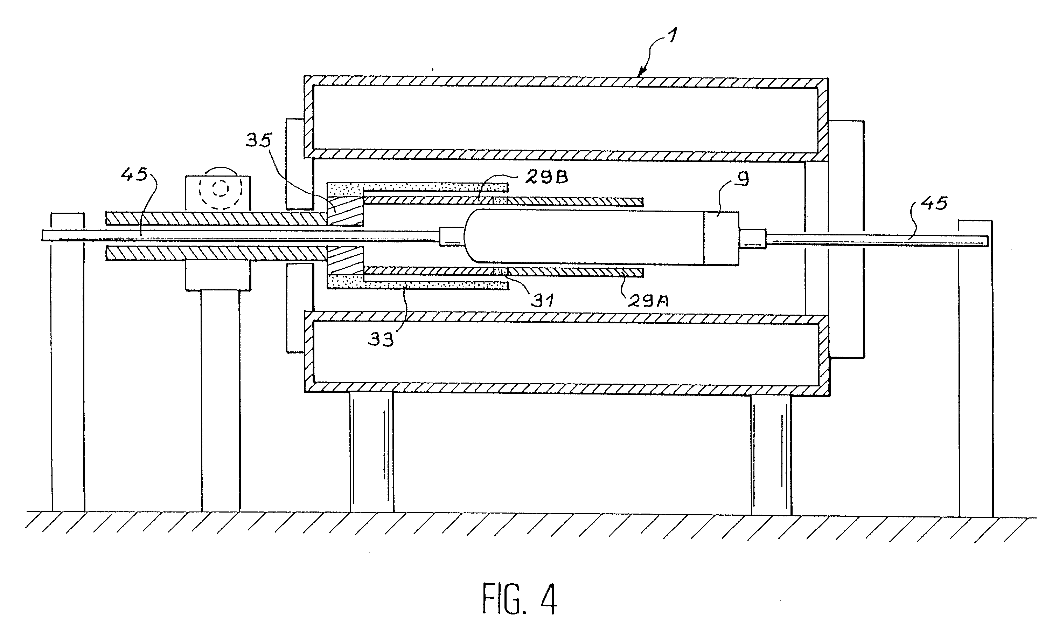

La figure 4 illustre une variante de réalisation de l'invention dans laquelle l'enceinte de cristallisation est horizontale.

Dans ce cas, l'enceinte chauffante 1 est horizontale. Le creuset 9 est maintenu à ses deux extrémités par des tiges 45 permettant le maintien du creuset dans la position horizontale fixe. Le dispositif de cristallisation 27 est identique à celui du mode de réalisation de la figure 1, si ce n'est que le fond 35 est percé de façon à permettre le passage de la tige 45.

## Revendications

1. Four de cristallisation pour matériau à faible conductivité thermique et/ou faible dureté, comprenant une enceinte chauffante (1), des moyens de chauffage (13) pour établir un profil de température selon l'axe de ladite enceinte et définir ainsi au moins une zone chaude (3) et au moins une zone froide (5) et un creuset (9) rempli d'une solution de soluté à cristalliser, dans un solvant, ledit creuset (9) étant fixe et étant placé dans l'enceinte chauffante (1) au niveau de la zone chaude (3), caractérisé en ce que le four comprend de plus :
- un dispositif de cristallisation (27) comprenant un homogénéïsateur thermique (29A) et un drain thermique (29B) séparés par une entretoise (31) thermiquement isolante, lesdits homogénéisateur thermique, drain thermique et entretoise isolante étant solidaires, et
- des moyens (37) pour déplacer ledit dispositif de cristallisation (27) selon l'axe de l'enceinte et autour dudit creuset (9).

2. Four de cristallisation selon la revendication 1, caractérisé en ce que le drain thermique (29B) présente, un fond (35) en matériau conducteur thermique.

3. Four de cristallisation selon la revendication 1, caractérisé en ce que l'entretoise (31) est réalisée dans un matériau isolant thermique choisi parmi l'alumine, la zircone ou les ciments réfractaires.

4. Four de cristallisation selon la revendication 1 ou 2, caractérisé en ce que l'homogénéïsateur et le drain thermique (39A,29B) et/ou le fond (35) conducteur thermique sont réalisés en carbure de silicium, en graphite ou en alliages réfractaires.

5. Four de cristallisation selon la revendication 1, caractérisé en ce que la zone froide (5) est refroidie progressivement au fur et à mesure du déplacement du dispositif de cristallisation (27) à l'intérieur de l'enceinte chauffante (1).

6. Four de cristallisation selon la revendication 1, caractérisé en ce qu'il comprend un dispositif de réglage fin (21) de la position du creuset (9) à l'intérieur de l'enceinte chauffante (1).

7. Four de cristallisation selon la revendication 1, caractérisé en ce que le creuset (9) est monté sur un dispositif anti-vibrations (25).

8. Four de cristallisation selon la revendication 1, caractérisé en ce que l'enceinte chauffante (1) est fermée et remplie d'un gaz.

9. Four de cristallisation selon la revendication 8, caractérisé en ce que le gaz est un gaz inerte, réducteur, oxydant ou un gaz comprenant un produit de dopage à l'état gazeux.

10. Four de cristallisation selon la revendication 1 caractérisé en ce que ledit dispositif de cristallisation (27) comprend en outre un écran tubulaire (33) isolant thermique, coaxial à l'homogénéïsateur thermique (29A) et au drain thermique (29B) et à l'entretoise isolante, et entourant le drain thermique (29B) et l'entretoise isolante (31).

11. Four de cristallisation selon la revendication 10 caractérisé en ce que ledit écran tubulaire est réalisé dans un matériau isolant thermique choisi parmi l'alumine, la zircone ou les ciments réfractaires.
